# EUROPÄISCHE PATENTSCHRIFT

(11) **EP 2 929 763 B1**
(45) Veröffentlichungstag und Bekanntmachung des Hinweises auf die Patenterteilung: **30.05.2018**
(21) Anmeldenummer: 13792679.6
(22) Anmeldetag: 18.11.2013
(51) Int. Cl.: H05K 5/00

(54) **STEUERGERÄT FÜR EIN KRAFTFAHRZEUG**
CONTROL DEVICE FOR A MOTOR VEHICLE
APPAREIL DE COMMANDE POUR VÉHICULE À MOTEUR

(30) Priorität: 10.12.2012 DE 102012222676; 15.11.2013 DE 102013223309
(43) Veröffentlichungstag der Anmeldung: 14.10.2015
(73) Patentinhaber: Robert Bosch GmbH, 70442 Stuttgart (DE)
(72) Erfinder: GUECKEL, Richard, 71701 Schwieberdingen (DE); KROECKEL, Markus, 71701 Schwieberdingen (DE)
(86) Internationale Anmeldenummer: PCT/EP2013/074109
(87) Internationale Veröffentlichungsnummer: WO 2014/090516

(56) Entgegenhaltungen:
- DE-A1-102008 051 545
- DE-A1-102010 025 086
- US-A- 5 231 561
- US-A1- 2009 258 543

## Beschreibung

### Stand der Technik

Die Erfindung betrifft ein Steuergerät für ein Kraftfahrzeug. Das Steuergerät weist ein Gehäuse und eine in dem Gehäuse angeordnete Leiterplatte auf, wobei ein Endabschnitt der Leiterplatte als Steckkontakt ausgebildet ist.
Bei Steuergeräten mit einer Leiterplatte, bei der ein Endabschnitt als Steckkontakt, insbesondere Direkt-Steckkontakt, ausgebildet ist, besteht das Problem, dass - bedingt durch Fertigungstoleranzen - der Steckkontakt, und somit elektrische Einzelkontakte des Steckkontakts, beim Zusammenstecken mit einem dem Steckkontakt entsprechenden Gegenstecker nicht oder fehlerhaft kontaktiert werden können, da wegen der Fertigungstoleranzen die Position der elektrischen Kontakte des Steckkontakts relativ zu entsprechenden Steckkontakten des Gegensteckers nur in Abhängigkeit der Fertigungstoleranzen festgelegt ist.

Das Dokument DE102010025086 offenbart ein Steuergerät gemäß dem Oberbegriff des Anspruchs 1.

### Offenbarung der Erfindung

Erfindungsgemäß weist wenigstens ein Gehäuseteil des Gehäuses der eingangs genannten Art wenigstens einen Zentrierstift auf, wobei der Zentrierstift ausgebildet ist, durch einen Durchbruch in der Leiterplatte hindurchzugreifen und die Leiterplatte in einer vorbestimmten Position in dem Gehäuse zu halten. So können die elektrischen Kontakte des Steckkontakts vorteilhaft genau in dem Gehäuse positioniert sein. Beim Zusammenstecken des Steuergeräts mit einem Gegenstecker kann der Steckkontakt so sicher von einem Gegensteckkontakt des Gegensteckers kontaktiert werden. Der Steckkontakt ragt durch einen Durchbruch in dem Gehäuse heraus. In einer anderen Ausführungsform ist der Steckkontakt angeordnet, durch eine Öffnung in dem Gehäuse von einem Gegenstecker kontaktiert zu werden. Bevorzugt ist an die Öffnung ein umlaufend ausgebildeter Steckkragen angeformt.
In einer bevorzugten Ausführungsform weist das Gehäuse im Bereich des Steckkontaktes der Leiterplatte einen Gehäusekragen auf, welcher den Steckkontakt umschließt. Weiter bevorzugt ist durch den Gehäusekragen eine Öffnung in dem Gehäuse ausgebildet, durch die der Steckkontakt kontaktiert werden kann. Durch den Gehäusekragen ist der Steckkontakt vorteilhaft vor äußeren mechanischen Einflüssen geschützt. Der Gehäusekragen dient bevorzugt als Steckerkragen für einen Gegenstecker, der die Kontakte auf der Leiterplatte kontaktiert.
Der Gehäusekragen ist bevorzugt einteilig mit einem Gehäuseteil ausgebildet, wodurch die Toleranzen der Position der elektrischen Kontakte der Leiterplatte relativ zu dem Gehäusekragen weiter minimiert werden können. Beispielsweise kann der Gehäusekragen in einem Spritzgussprozess einschüssig mit dem Gehäuseteil hergestellt werden. Ein separates Anbringen des Gehäusekragens ist somit nicht erforderlich.
In einer bevorzugten Ausführungsform ist der Zentrierstift zu einem Ende hin verjüngt, insbesondere kegelförmig, ausgebildet. Bevorzugt ist der Durchbruch entsprechend einer Querschnittsform des Zentrierstiftes ausgebildet. Bevorzugt ist der Zentrierstift kreiskegelförmig ausgebildet und der Durchbruch kreisförmig ausgebildet. So kann die Leiterplatte, und so auch der Steckkontakt, beim Zusammenfügen des Gehäuseteils mit einem weiteren Gehäuseteil, und so beim Eingreifen des Zentrierstiftes in den Durchbruch der Leiterplatte, positionsgenau in dem Gehäuse angeordnet werden.
In einer bevorzugten Ausführungsform weist der Durchbruch in der Leiterplatte eine Form auf, die der Form des Zentrierstiftes, insbesondere einer äußeren Form des Zentrierstiftes, entspricht. Bevorzugt weist der Durchbruch in der Leiterplatte eine Form auf, die - insbesondere entlang einer Dickenerstreckung der Leiterplatte - einem Kegellängsabschnitt entspricht, und der Zentrierstift ist kegelförmig ausgebildet. Weiter bevorzugt ist der Zentrierstift kreiskegelförmig ausgebildet und der Durchbruch in der Leiterplatte weist eine Form auf, die einem Kreiskegelabschnitt, insbesondere einem Längsabschnitt eines Kreiskegels, entspricht. So kann vorteilhaft ein Leiterplattenrand im Bereich des Durchbruchs keine scharfe Kante bilden, welche beim Eingreifen des Zentrierstiftes in den Durchbruch, und weiter beim Anschlagen des Durchbruchrandes gegen eine Mantelfläche des Zentrierstiftes, in die Mantelfläche des Zentrierstiftes einschneidet. So kann vorteilhaft eine Fläche der Leiterplatte, insbesondere eine Innenwand im Bereich des Durchbruchs der Leiterplatte, vollflächig an einer Oberfläche des Zentrierstiftes auf einem Abschnitt des Zentrierstiftes anliegen, der im Durchbruch der Leiterplatte angeordnet ist. Vorteilhaft kann die Leiterplatte zwischen dem Zentrierstift und dem Gegenlager eingeklemmt sein.

Der Zentrierstift ist bevorzugt ausgebildet, beim Schließen der Gehäuseteile die Leiterplatte gegen das Gegenlager zu pressen und so festzuhalten. Die Leiterplatte ist so durch den Zentrierstift und das Gegenlager vorteilhaft sowohl richtig positioniert als auch festgehalten.

In einer bevorzugten Ausführungsform weist das Gehäuse ein Gegenlager auf, welches ausgebildet ist, einen Endabschnitt des Zentrierstiftes aufzunehmen und zu halten. Der Zentrierstift ist so vorteilhaft in dem Gegenlager geführt und kann auch bei Vibrationen, die auf das Steuergerät einwirken, die Leiterplatte sicher in ihrer vorbestimmten Position in dem Gehäuse halten.

In einer bevorzugten Ausführungsform ist das Gegenlager ausgebildet, die Leiterplatte zu tragen, wobei wenigstens ein Teil der Leiterplatte auf dem Gegenlager liegend angeordnet ist. Das Gegenlager bildet so vorteilhaft eine Auflagefläche für die Leiterplatte, gegen die die Leiterplatte beim Einführen in das Gehäuse anschlagen kann und durch das eine Position der Leiterplatte in dem Gehäuse festgelegt ist. Zusätzlich bildet das Gegenlager vorteilhaft eine Aufnahme und Fixierung des Zentrierstiftes.

In einer bevorzugten Ausführungsform weist das Gehäuse im Bereich des Steckkontaktes der Leiterplatte einen Gehäusekragen auf, welcher den Steckkontakt umschließt. Weiter bevorzugt ist durch den Gehäusekragen eine Öffnung in dem Gehäuse ausgebildet, durch die der Steckkontakt kontaktiert werden kann. Durch den Gehäusekragen ist der Steckkontakt vorteilhaft vor äußeren mechanischen Einflüssen geschützt. Weiter vorteilhaft kann durch den Gehäusekragen ein Führungsmittel gebildet sein, welches ausgebildet ist, ein Zusammenstecken mit einem Gegenstecker bis zu einer vorbestimmten Endposition des Gegensteckers, bei dem elektrische Steckkontakte des Gegensteckers mit dem Steckkontakt verbunden sind, zu führen.
In einer bevorzugten Ausführungsform weist das Gehäuse im Bereich des Steckkontaktes eine Dichtung auf und ist ausgebildet, beim Verbundenwerden mit einem Gegenstecker gegen den Gegenstecker abzudichten. Weiter bevorzugt ist die Dichtung im Bereich des Gehäusekragens angeordnet. Beispielsweise ist die Dichtung durch eine Radialdichtung gebildet, welche an dem Gehäusekragen umlaufend angeordnet ist und radial zu einer Steckrichtung nach außen weist.
Mittels des Zentrierstiftes kann so vorteilhaft auch eine Abdichtung mit dem Gegenstecker verbessert werden, insoweit bei einer fehlerhaften Positionierung der Leiterplatte beim Zusammenstecken des Steuergerätes mit dem Gegenstecker die Positionsabweichung durch die zuvor beschriebene Dichtung bei großen Abweichungen nicht kompensiert werden kann. Die Dichtung wird dann beispielsweise durch einen den Gehäusekragen umschließenden Gegenkragen des Gegensteckers wenigstens auf einem Längsabschnitt komprimiert, wohingegen die Dichtung auf einem dem Längsabschnitt gegenüberliegenden Längsabschnitt eine geringere Kompression erfährt, und womöglich nicht ausreichend kontaktiert wird, um eine Dichtheit einer Anordnung, umfassend das Steuergerät und den Gegenstecker, nach außen hin abzudichten.

Die Erfindung betrifft auch ein Verfahren zum Positionieren einer Leiterplatte gemäß Anspruch 9. Bevorzugt wird bei dem Verfahren die Leiterplatte nach dem Bewegen entlang ihrer flachen Erstreckung quer zur flachen Erstreckung in eine Endposition bewegt.
Insbesondere durch die Ausbildung des Gehäuses mit einer Öffnung mit einem angeformten Gehäusekragen wird es demnach möglich, die Leiterplatte senkrecht von oben automatisiert in das Gehäuseteil einzusetzen und durch horizontales Verschieben in eine Endposition zu bringen. Damit wird in vorteilhafter Weise eine automatisierte Montage umsetzbar, die insbesondere ohne komplizierte Drehbewegungen auskommt.
In einer bevorzugten Ausführungsform wird das Gehäuse zusammen mit der Leiterplatte mit einem mit einem Kabel verbundenen Gegenstecker verbunden, wobei das Gehäuse im Bereich des Steckkontaktes mit dem Gegenstecker abdichtet.
Vorteilhaft kann so ein Stecksystem, umfassend das Steuergerät und den Gehäusestecker gebildet sein.
Die Erfindung wird nun im Folgenden anhand von Figuren und weiteren Ausführungsbeispielen beschrieben. Weitere vorteilhafte Ausführungsvarianten ergeben sich aus den in den Figuren und in den abhängigen Ansprüchen beschriebenen Merkmalen.
Figur 1 zeigt ein Ausführungsbeispiel für ein Steuergerät mit einer Leiterplatte, die in einem Gehäuse angeordnet ist, und einen Verfahrensschritt zum Herstellen des Steuergeräts;
Figur 2 zeigt das in Figur 1 dargestellte Steuergerät mit einem weiteren Gehäuseteil, das einen Gehäusedeckel bildet und zwei weitere Verfahrensschritte zur Herstellung des Steuergeräts;
Figur 3 zeigt ein Ausführungsbeispiel für ein Zentriersystem umfassend Komponenten, die Bestandteile des in den Figuren 1 und 2 dargestellten Steuergeräts sein können.

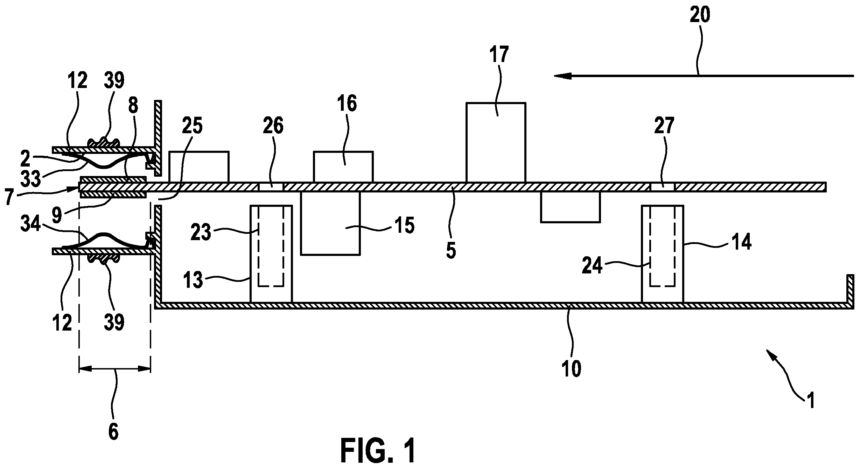

Figur 1 zeigt ein Ausführungsbeispiel für ein Steuergerät 1. Das Steuergerät 1 weist eine Leiterplatte 5 auf. Die Leiterplatte 5 weist wenigstens eine Substratschicht, und wenigstens eine elektrisch leitfähige Schicht auf. Die elektrisch leitfähige Schicht bildet beispielsweise elektrisch leitfähige Leiterbahnen aus, welche jeweils elektrische Anschlüsse von Bauelementen miteinander verbinden. Mit der Leiterplatte 5 sind auch elektronische Bauelemente verbunden, von denen die Bauelemente 15, 16 und 17 beispielhaft bezeichnet sind. Die Leiterplatte 5 weist an einem Endabschnitt 6 einen Steckkontakt 7 auf. Der Steckkontakt 7 ist in diesem Ausführungsbeispiel als Direkt-Steckkontakt ausgebildet. Dazu weist die Leiterplatte 5 im Bereich des den Steckkontakt 7 bildenden Endabschnitts 6 wenigstens auf einer Leiterplattenseite, in diesem Ausführungsbeispiel auf beiden Leiterplattenseiten, Kontakte auf, welche jeweils durch eine elektrisch leitfähige Schicht, insbesondere eine Leiterbahn der Leiterplatte 5, gebildet sind. Die Kontakte 8 und 9 sind in der in Figur 1 dargestellten Schnittdarstellung bezeichnet.

Das Steuergerät 1 weist auch ein Gehäuse auf, von dem ein Gehäuseteil 10 dargestellt ist. Das Gehäuseteil 10 bildet in diesem Ausführungsbeispiel eine Unterseite des Gehäuses. Das Gehäuseteil 10, welches längs gestreckt ausgebildet ist, weist im Bereich einer Stirnseite einen Durchbruch 25 auf. Das Gehäuseteil 10 weist im Bereich des Durchbruchs 25 einen Steckkragen 12 auf, welcher den Durchbruch 25 umschließt. Der Steckkragen 12 umschließt einen Hohlraum, welcher an den Durchbruch 25 anschließt. Der Endabschnitt 6 der Leiterplatte 5, welcher den Steckkontakt 7 ausbildet, kann durch den Durchbruch 25 in den Hohlraum des Steckkragens 12 eingeführt werden.

Der Steckkragen 12 weist an einer Innenwand 2 radial nach innen gerichtete Federelemente 33 und 34 auf. Die Federelemente 33 und 34 sind jeweils radial nach innen federnd ausgebildet. Die Federelemente 33 und 34 sind jeweils ausgebildet, einen Endabschnitt eines Gegensteckers kraftschlüssig zu halten.

Das Gehäuseteil 10 weist in diesem Ausführungsbeispiel zwei Gegenlager 13 und 14 auf, welche jeweils als Dom ausgebildet sind. Das Gegenlager 13 weist einen als Sackloch ausgebildeten Hohlraum 23 auf und das Gegenlager 14 weist einen als Sackloch ausgebildeten Hohlraum 24 auf. Die Leiterplatte 5 weist zwei Durchbrüche 26 und 27 auf. Der Durchbruch 26 liegt in der in Figur 1 dargestellten Position der Leiterplatte 5 dem Hohlraum 23 gegenüber und der Durchbruch 27 liegt dem Hohlraum 24 gegenüber.

Im Folgenden wird nun ein Fertigungsverfahren zum Erzeugen des Kontaktsystems 1 beschrieben:
In einem ersten Schritt wird die Leiterplatte 5 entlang einer Richtung 20, welche in Richtung der flachen Erstreckung der Leiterplatte 5 verläuft, mit einer translatorischen Bewegung mit dem Gehäuseteil 10 derart zusammengeführt, dass der den Steckkontakt 7 ausbildende Endabschnitt 6 der Leiterplatte 5 durch den Durchbruch 25 hindurchgeschoben wird. Die Leiterplatte 5 ist dabei von den Gegenlagern 13 und 14 beabstandet. Die Leiterplatte 5 wird entlang der Richtung 20 so weit bewegt, bis die Durchbrüche 26 und 27 den Hohlräumen 23 beziehungsweise 24 einander gegenüberliegend angeordnet sind.

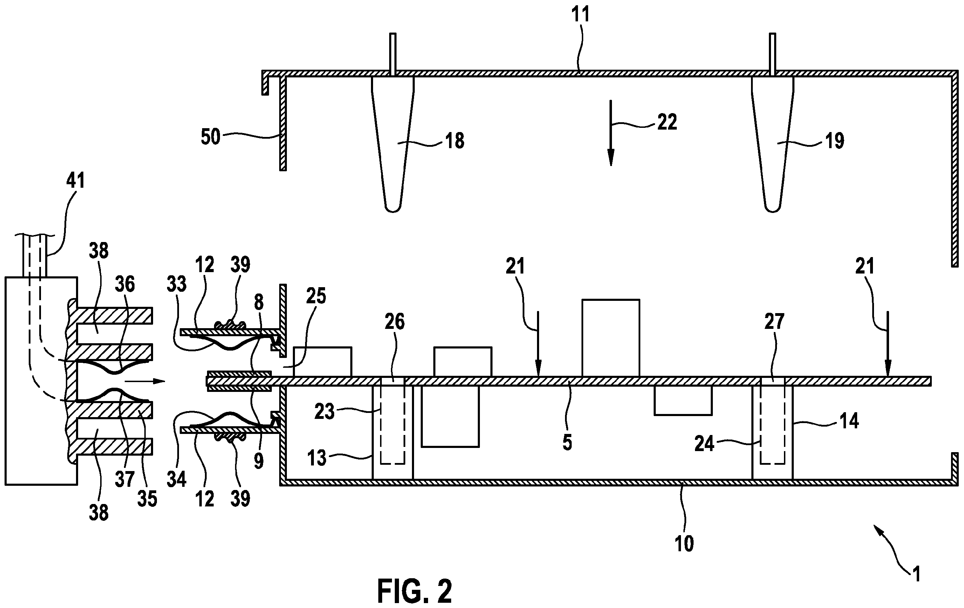

Die weiteren Fertigungsschritte sind im Folgenden in Figur 2 beschrieben.

Figur 2 zeigt das in Figur 1 bereits dargestellte Steuergerät 1. Zusätzlich zu dem in Figur 1 dargestellten Steuergerät 1 zeigt Figur 2 ein weiteres Gehäuseteil 11 des Gehäuses des Kontaktsystems 1, wobei das Gehäuseteil 11 in diesem Ausführungsbeispiel einen Gehäusedeckel bildet. An das Gehäuseteil 11 sind - voneinander beabstandet - zwei jeweils entlang ihrer Längserstreckung zu einem Ende hin verjüngt ausgebildete Zentrierstifte 18 und 19 angeformt. Weiterhin weist das Gehäuseteil 11 in einem Bereich, der in zusammengebautem Zustand des Kontaktsystems 1 dem Steckkragen 12 benachbart ist, eine Blende 50 auf. Durch die Blende 50 wird insbesondere der Fügespalt in diesem Bereich reduziert und das Eindringen von Fremdkörpern verhindert.
Die Leiterplatte 5 wird nun in einem zweiten Schritt entlang einer Richtung 21, wobei die Richtung 21 quer zur in Figur 1 dargestellten Richtung 20 verläuft, auf die Gegenlager 23 und 24 zubewegt, bis die Leiterplatte 5 mit Randbereichen im Bereich der Durchbrüche 26 beziehungsweise 27, auf eine Stirnseite der Gegenlager 23 beziehungsweise 24 anschlägt. Die Leiterplatte 5 ist während des zweiten Schritts beim Senken auf die Gegenlager 23 und 24 mit dem Endabschnitt 6 in dem Durchbruch 25 angeordnet. Der Endabschnitt 6 wird beim zuvor beschriebenen Bewegen in Richtung der Gegenlager 13 und 14, in den von dem Steckkragen 12 umschlossenen Hohlraum bewegt.

Das Gehäuseteil 11 kann nun in einem dritten Schritt zusammen mit den Zentrierstiften 18 und 19 entlang einer Richtung 22, welche in Richtung der zuvor beschriebenen Richtung 21 verläuft, also quer zu einer flachen Erstreckung der Leiterplatte 5, zum Verschließen der Gehäuseteile 10 und 11, auf das Gehäuseteil 10 zubewegt werden. Dabei greifen die Zentrierstifte 18 und 19, durch die Durchbrüche 26 beziehungsweise 27 der Leiterplatte 5 hindurch, in die Hohlräume 23 und 24 der Gegenlager 13 beziehungsweise 14 hinein. Die Leiterplatte 5 wird so positionsgenau in dem Gehäuse, umfassend die Gehäuseteile 10 und 11, angeordnet.

Das in Figur 2 dargestellte Steuergerät 1 umfasst auch einen Gegenstecker 35 mit einem Verbindungskabel 41, welcher ausgebildet ist, mit einem Endabschnitt mit dem zuvor beschriebenen Gehäuse umfassende Gehäuseteile 10 und 11, insbesondere dem Steckkragen 12, zusammengesteckt zu werden. Der Gegenstecker 35 weist im Bereich des Endabschnitts zwei elektrisch leitfähige, radial in einen Hohlraum des Endabschnitts des Gegensteckers 35 weisende Federkontakte 36 und 37 auf. Beim Zusammenstecken des Gegensteckers 35 mit dem Steckkragen 12 kann der Federkontakt 36 den Kontakt 8, und der Federkontakt 37 den Kontakt 9 elektrisch schleifend kontaktieren. Der Gegenstecker 35 weist einen im Bereich des Endabschnitts ausgebildeten, umlaufenden Ringspalt 38 auf. Der Ringspalt 38 des Gegensteckers 35 ist ausgebildet, den Steckkragen 12 des Gehäuseteils 10 beim Zusammenstecken wenigstens teilweise aufzunehmen. Die Federelemente 33 und 34 drücken dabei gegen eine Innenwand des Ringspalts 38.

Der Steckkragen 12 weist auch eine umlaufende, radial nach außen weisende, Dichtung 39 auf. Die Dichtung 39 ist in diesem Ausführungsbeispiel durch ein Elastomer gebildet. Das Elastomer ist beispielsweise ein Silikongummi. Die Dichtung 39 weist in diesem Ausführungsbeispiel drei radial nach außen weisende Dichtlippen auf. Die Dichtung 39 ist ausgebildet, den Gegenstecker 35 gegen das Gehäuseteil 10, insbesondere den Steckkragen 12, abzudichten. So kann vorteilhaft kein Schmutz oder keine Feuchtigkeit an der Schnittstelle zwischen dem Gegenstecker 35 und dem Gehäuseteil 10 in den von dem Steckkragen 12 umschlossenen Hohlraum, und so auch nicht durch den Durchbruch 25 hindurch in das Gehäuseinnere des die Gehäuseteile 10 und 11 umfassenden Gehäuses dringen.

Die elektrische Verbindung zwischen dem Kontakt 8 und dem Federkontakt 36, und dem Kontakt 9 und dem Federkontakt 37 ist so vor eindringender Feuchtigkeit oder eindringender Verschmutzung geschützt. Der Gegenstecker 35 weist auch ein Verbindungskabel 41 auf, welches elektrische Verbindungsleitungen aufweist, die zu Kontaktfedern wie den Kontaktfedern 36 und 37 des Gegensteckers 35 führen und mit diesen verbunden sind.

Vorteilhaft kann das Steuergerät 1 so durch das Gehäuse zusammen mit der Leiterplatte 5 ein Steckmodul bilden, welches mit dem Gegenstecker 35, welcher als Kabelstecker ausgebildet ist, zusammengesteckt werden kann.

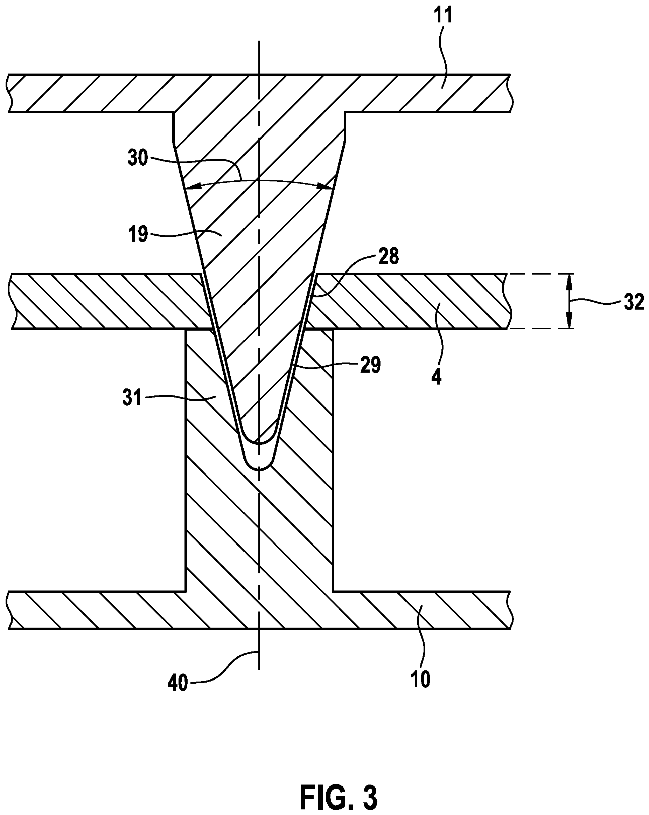

Figur 3 zeigt ein Ausführungsbeispiel für ein Zentriersystem, welches an dem Steuergerät 1 in den Figuren 1 und 2 verwirklicht sein kann. Dazu ist mit dem Gehäuseteil 10 anstelle des Gegenlagers 13 oder 14 ein Gegenlager 31 verbunden. Das Gegenlager 31 weist einen Hohlraum 29 auf, welcher als zu einem Ende hin verjüngt ausgebildetes Sackloch ausgebildet ist.

Die Verjüngung des Hohlraums 29 entspricht dabei einer Verjüngung des Zentrierstiftes 19. Die Verjüngung des Zentrierstiftes 19 und des Hohlraums 29 ist in der in Figur 3 dargestellten Schnittdarstellung mit dem Winkel 30 bezeichnet. Dargestellt ist auch eine Leiterplatte 4 anstelle der Leiterplatte 5, welche einen Durchbruch 28 aufweist. Der Durchbruch 28 ist in diesem Ausführungsbeispiel - anders als in den Figuren 1 und 2 - nicht hohlzylinderförmig, sondern als Hohlkegel-Längsabschnitt ausgebildet.

Der Hohlkegel-Längsabschnitt, welcher sich entlang einer Leiterplattendicke 32 der Leiterplatte 4 erstreckt, entspricht in seiner Form einem Längsabschnitt des Zentrierstiftes 19 entlang der Längsachse 40.

Mit dem Zentriersystem gemäß Figur 3 als Bestandteil des Kontaktsystems 1 kann ein Leiterplattenrand der Leiterplatte 4 im Bereich des Durchbruchs 28 nicht in den Zentrierstift 19 einschneiden. So ist auch bei Vibrationen bei einem Betrieb eines Kraftfahrzeugs, in dem das Steuergerät angeordnet ist sichergestellt, dass ein Rand der Leiterplatte 4 im Bereich des Durchbruchs 28 nicht in den Zentrierstift 19 einschneiden kann. Die Positionierung der Leiterplatte 4 in dem Gehäuse, umfassend die Gehäuseteile 10 und 11, ist so dauerhaft gesichert.

Das Steuergerät ist bevorzugt ausgebildet, einen Motor eines Kraftfahrzeugs mit einer Verbrennungsmaschine und/oder einer elektrischen Maschine anzusteuern. Weiter bevorzugt ist das Steuergerät ausgebildet, eine Bremsanlage, ein Fahrerassistenzsystem, beispielsweise Spurhalteassistent, eine Beleuchtungsanlage oder eine Türverriegelung des Kraftfahrzeugs zu steuern.

## Patentansprüche

1. Steuergerät (1) für ein Kraftfahrzeug,
mit einem Gehäuse (10, 11) und einer in dem Gehäuse (10, 11) angeordneten Leiterplatte (4, 5), wobei ein Endabschnitt (6) der Leiterplatte als Steckkontakt (7) ausgebildet ist, welcher beim Zusammenstecken des Steuergeräts (1) mit einem Gegenstecker von einem Gegensteckkontakt des Gegensteckers kontaktiert werden kann,
**dadurch gekennzeichnet, dass**
ein Gehäuseteil (10) im Bereich einer Stirnseite einen Öffnung (25) aufweist, und
wobei der Steckkontakt (7) durch die Öffnung (25) im Gehäuseteil (10) herausragt oder derart angeordnet ist, dass der Steckkontakt (7) durch die Öffnung (25) im Gehäuseteil (10) von einem Gegenstecker kontaktiert werden kann, und
wenigstens ein weiteres Gehäuseteil (11) des Gehäuses (10, 11) wenigstens einen Zentrierstift (18, 19) aufweist, welcher ausgebildet ist, durch einen Durchbruch (26, 27) in der Leiterplatte (4, 5) hindurchzugreifen und die Leiterplatte (4, 5) in einer vorbestimmten Position in dem Gehäuse (10, 11) zu halten.

2. Steuergerät (1) nach Anspruch 1,
**dadurch gekennzeichnet, dass**
das Gehäuse (10, 11) im Bereich des Steckkontaktes (7) der Leiterplatte (4, 5) einen Gehäusekragen (12) aufweist, welcher den Steckkontakt (7) umschließt und durch den Gehäusekragen (12) eine Öffnung in dem Gehäuse (10, 11) ausgebildet ist, durch die der Steckkontakt (7) kontaktiert werden kann.

3. Steuergerät (1) nach einem der Ansprüche 1 oder 2,
**dadurch gekennzeichnet, dass**
der Zentrierstift (18, 19) zu einem Ende hin verjüngt, insbesondere kegelförmig ausgebildet ist, und der Durchbruch (26, 27) entsprechend einer Querschnittsform des Zentrierstiftes (18, 19) ausgebildet ist.

4. Steuergerät (1) nach Anspruch 3,
**dadurch gekennzeichnet, dass**
der Durchbruch (26, 27) in der Leiterplatte (4, 5) eine Form aufweist, die einem Kegellängsabschnitt entspricht.

5. Steuergerät (1) nach einem der vorhergehenden Ansprüche,
**dadurch gekennzeichnet, dass**
das Gehäuse (10, 11) eine Gegenlager (13, 14) aufweist, welches ausgebildet ist, einen Endabschnitt des Zentrierstiftes (18, 19) aufzunehmen und zu halten.

6. Steuergerät (1) nach Anspruch 5,
**dadurch gekennzeichnet, dass**
das Gegenlager (13, 14) ausgebildet ist, die Leiterplatte (4, 5) zu tragen und wenigstens ein Teil der Leiterplatte (4, 5) auf dem Gegenlager (13, 14) liegend angeordnet ist.

7. Steuergerät (1) nach einem der vorhergehenden Ansprüche,
**dadurch gekennzeichnet, dass**
das Gehäuse (10, 11) im Bereich des Steckkontaktes (7) eine Dichtung (39) aufweist, die ausgebildet ist, beim Verbundenwerden mit einem Gegenstecker (35) gegen den Gegenstecker (35) abzudichten.

8. Steuergerät (1) nach einem der Ansprüche 2 bis 7,
**dadurch gekennzeichnet, dass**
das weitere
Gehäuseteil das weiteres (11) im Bereich des Gehäusekragens (12) eine Blende (50) aufweist die ausgebildet ist, beim Verbundenwerden der Gehäuseteile (10, 11) den Fügespalt zu reduzieren und das Eindringen von Fremdkörpern in das Gehäuse (10, 11) zu verhindern.

9. Verfahren zum Positionieren einer Leiterplatte (4, 5) in einem Gehäuse (10, 11) eines Steuergeräts (1) für ein Kraftfahrzeug,
wobei ein Endabschnitt (6) der Leiterplatte (4, 5) als Steckkontakt (7) ausgebildet ist, welcher beim Zusammenstecken des Steuergeräts (1) mit einem Gegenstecker von einem Gegensteckkontakt des Gegensteckers kontaktiert werden kann,
wobei in einem Verfahrensschritt die Leiterplatte quer zu ihrer flachen Erstreckung in einen Gehäuseteil (10) eines Gehäuses (10, 11) eingeführt wird, und in einem weiteren Schritt in ihrer flachen Erstreckung bewegt wird (20), bis der Endabschnitt (6) im Bereich einer Öffnung (25) des Gehäuses (10, 11) angeordnet ist, sodass der Steckkontakt (7) durch eine Öffnung (25) in der Stirnseite des Gehäuseteils (10) herausragt oder derart angeordnet ist, dass der Steckkontakt (7) durch die Öffnung (25) im ersten Gehäuseteil (10) von einem Gegenstecker kontaktiert werden kann,
und in einem weiteren Schritt der Gehäuseteil (10) mit einem weiteren Gehäuseteil (11) verbunden, insbesondere geschlossen wird, wobei wenigstens ein zu einem Ende hin verjüngt ausgebildeter, mit dem weiteren Gehäuseteil (11) verbundener Zentrierstift (18, 19) durch einen Durchbruch (26, 27) der Leiterplatte (4, 5) hindurchgreift bis der Zentrierstift (18, 19) mit einem Längsabschnitt formschlüssig gegen die Leiterplatte im Bereich des Leiterplattendurchbruchs (26, 27) schlägt und die Leiterplatte so in dem Gehäuse (10, 11) in einer vorbestimmten Position hält.

10. Verfahren nach Anspruch 9,
bei dem die Leiterplatte (4, 5) senkrecht von oben in den Gehäuseteil (10) eingeführt wird und durch horizontales Verschieben (20) in eine Endposition bewegt wird.

11. Verfahren nach Anspruch 10,
bei dem die Leiterplatte (4, 5) nach dem Bewegen entlang ihrer flachen Erstreckung quer zur flachen Erstreckung in eine Endposition bewegt wird (21).

12. Verfahren nach einem der vorhergehenden Ansprüche 9 bis 11,
**dadurch gekennzeichnet, dass**
Gehäuse (10, 11) zusammen mit der Leiterplatte (4, 5) mit einem mit einem Kabel (41) verbundenen Gegenstecker (35) verbunden wird und das Gehäuse (10, 11) im Bereich des Steckkontaktes (7) mit dem Gegenstecker (35) abdichtet.

## Claims

1. Control device (1) for a motor vehicle,
comprising a housing (10, 11) and a printed circuit board (4, 5) which is arranged in the housing (10, 11), wherein an end section (6) of the printed circuit board is in the form of a plug-in contact (7) which, when the control device (1) is plug-connected to a mating plug, can be contacted by a mating plug-in contact of the mating plug,
**characterized in that**
a housing part (10) has an opening (25) in the region of one end side, and
wherein the plug-in contact (7) protrudes through the opening (25) in the housing part (10) or is arranged in such a way that the plug-in contact (7) can be contacted by a mating plug through the opening (25) in the housing part (10), and
at least one further housing part (11) of the housing (10, 11) has at least one centring pin (18, 19) which is designed to pass through an aperture (26, 27) in the printed circuit board (4, 5) and to hold the printed circuit board (4, 5) in a predetermined position in the housing (10, 11).

2. Control device (1) according to Claim 1,
**characterized in that**
the housing (10, 11) has a housing collar (12) in the region of the plug-in contact (7) of the printed circuit board (4, 5), which housing collar surrounds the plug-in contact (7) and an opening in the housing (10, 11) is formed through the housing collar (12), it being possible for the plug-in contact (7) to be contacted through the said opening.

3. Control device (1) according to either of Claims 1 and 2,
**characterized in that**
the centring pin (18, 19) tapers in the direction of one end, in particular is designed in the form of a cone, and the aperture (26, 27) is formed in a corresponding manner to a cross-sectional shape of the centring pin (18, 19).

4. Control device (1) according to Claim 3,
**characterized in that**
the aperture (26, 27) in the printed circuit board (4, 5) has a shape which corresponds to a cone longitudinal section.

5. Control device (1) according to one of the preceding claims,
**characterized in that**
the housing (10, 11) has a mating bearing (13, 14) which is designed to receive and to hold an end section of the centring pin (18, 19).

6. Control device (1) according to Claim 5,
**characterized in that**
the mating bearing (13, 14) is designed to support the printed circuit board (4, 5), and at least one portion of the printed circuit board (4, 5) is arranged so as to lie on the mating bearing (13, 14).

7. Control device (1) according to one of the preceding claims,
**characterized in that**
the housing (10, 11) has a seal (39) in the region of the plug-in contact (7), which seal is designed to seal off with respect to the mating plug (35) when connection is made with a mating plug (35).

8. Control device (1) according to one of Claims 2 to 7,
**characterized in that**
the further housing part the further (11) has a panel (50) in the region of the housing collar (12), which panel is designed to reduce the joining gap and to prevent the ingress of foreign bodies into the housing (10, 11) when the housing parts (10, 11) are connected.

9. Method for positioning a printed circuit board (4, 5) in a housing (10, 11) of a control device (1) for a motor vehicle,
wherein an end section (6) of the printed circuit board (4, 5) is in the form of a plug-in contact (7) which, when the control device (1) is plug-connected to a mating plug, can be contacted by a mating plug-in contact of the mating plug,
wherein in one method step the printed circuit board is inserted into a housing part (10) of a housing (10, 11) transversely to its flat extent, and in a further step is moved (20) in its flat extent until the end section (6) is arranged in the region of an opening (25) in the housing (10, 11), so that the plug-in contact (7) protrudes through an opening (25) in the end side of the housing part (10) or is arranged in such a way that the plug-in contact (7) can be contacted by a mating plug through the opening (25) in the first housing part (10),
and in a further step the housing part (10) is connected to, in particular closed by, a further housing part (11), wherein at least one centring pin (18, 19) which is designed to taper in the direction of one end and is connected to the further housing part (11) passes through an aperture (26, 27) in the printed circuit board (4, 5) until the centring pin (18, 19), by way of a longitudinal section, strikes the printed circuit board in the region of the printed circuit board aperture (26, 27) in an interlocking manner and holds the printed circuit board in a predetermined position in the housing (10, 11) in this way.

10. Method according to Claim 9,
in which the printed circuit board (4, 5) is inserted into the housing part (10) perpendicularly from above and is moved to an end position by horizontal displacement (20).

11. Method according to Claim 10,
in which the printed circuit board (4, 5), after being moved along its flat extent, is moved (21) to an end position transversely to the flat extent.

12. Method according to one of the preceding Claims 9 to 11,
**characterized in that**
the housing (10, 11), together with the printed circuit board (4, 5), is connected to a mating plug (35) which is connected to a cable (41), and the housing (10, 11) is sealed off in the region of the plug-in contact (7) with the mating plug (35).

## Revendications

1. Appareil de commande (1) pour un véhicule à moteur,
comportant un boîtier (10, 11) et une carte de circuit imprimé (4, 5) disposée dans le boîtier (10, 11), dans lequel une section d'extrémité (6) de la carte de circuit imprimé est réalisée sous la forme d'un contact enfichable (7) qui, lors de l'enfichage de l'appareil de commande (1) avec une contre-fiche, peut être mis en contact avec un contre-contact enfichable de la contre-fiche,
**caractérisé en ce qu'**une partie de boîtier (10) présente dans une face avant une ouverture (25), et dans lequel le contact enfichable (7) fait saillie à travers l'ouverture (25) pratiquée dans la partie de boîtier (10) ou est agencé de manière à ce que le contact enfichable (7) puisse être mis en contact avec une contre-fiche à travers l'ouverture (25) pratiquée dans la partie de boîtier (10), et
au moins une autre partie de boîtier (11) du boîtier (10, 11) comporte au moins une pointe de centrage (18, 19) qui est conçue pour s'engager à travers un orifice traversant (26, 27) pratiqué dans la carte de circuit imprimé (4, 5) et pour maintenir la carte de circuit imprimé (4, 5) à une position prédéterminée dans le boîtier (10, 11).

2. Appareil de commande (1) selon la revendication 1,
**caractérisé en ce que** le boîtier (10, 11) comporte, dans la zone du contact enfichable (7) de la carte de circuit imprimé (4, 5), un collet de boîtier (12) qui entoure le contact enfichable (7) et **en ce qu'**une ouverture pratiquée dans le boîtier (10, 11) est formée par le collet de boîtier (12), à travers laquelle un contact peut être établi avec le contact enfichable (7).

3. Appareil de commande (1) selon l'une des revendications 1 ou 2,
**caractérisé en ce que** la pointe de centrage (18, 19) se rétrécit vers une extrémité, et est notamment réalisée sous la forme d'un cône, et **en ce que** l'orifice traversant (26, 27) est réalisé d'une manière qui correspond à une forme de section transversale de la pointe de centrage (18, 19).

4. Appareil de commande (1) selon la revendication 3,
**caractérisé en ce que** l'orifice traversant (26, 27) pratiqué dans la carte de circuit imprimé (4, 5) présente une forme qui correspond à une section longitudinale de cône.

5. Appareil de commande (1) selon l'une des revendications précédentes,
**caractérisé en ce que** le boîtier (10, 11) comporte un contre-palier (13, 14) qui est conçu pour recevoir une section d'extrémité de la pointe de centrage (18, 19) et pour la maintenir.

6. Appareil de commande (1) selon la revendication 5,
**caractérisé en ce que** le contre-palier (13, 14) est conçu pour porter la carte de circuit imprimé (4, 5) et **en ce qu'**au moins une partie de la carte de circuit imprimé (4, 5) est disposée de manière à reposer sur le contre-palier (13, 14).

7. Appareil de commande (1) selon l'une des revendications précédentes,
**caractérisé en ce que** le boîtier (10, 11) comporte, dans la zone du contact enfichable (7), un élément d'étanchéité (39) qui est conçu pour réaliser l'étanchéité contre une contre-fiche (35) lors de son raccordement à la contre-fiche (35).

8. Appareil de commande (1) selon l'une des revendications 2 à 7,
**caractérisé en ce que** l'autre partie de boîtier l'autre (11) comporte, dans la zone du collet de boîtier (12), un diaphragme (50) qui est conçu pour réduire la fente de jonction lors de l'assemblage des parties de boîtier (10, 11) et pour empêcher la pénétration de corps étrangers dans le boîtier (10, 11).

9. Procédé pour positionner une carte de circuit imprimé (4, 5) dans un boîtier (10, 11) d'un appareil de commande (10) destiné à un véhicule,
dans lequel une section d'extrémité (6) de la carte de circuit imprimé (4, 5) est réalisée sous la forme d'un contact enfichable (7) qui, lors de l'enfichage de l'appareil de commande (1) avec une contre-fiche, peut être mis en contact avec un contre-contact enfichable de la contre-fiche,
dans lequel, lors d'une étape du procédé, la carte de circuit imprimé est insérée transversalement à son extension plane dans une partie de boîtier (10) d'un boîtier (10, 11) et, lors d'une autre étape, celle-ci est déplacée (20) le long de son extension plane jusqu'à ce que la section d'extrémité (6) soit disposée dans la zone d'une ouverture (25) du boîtier (10, 11), de manière à ce que le contact enfichable (5) fasse saillie à travers une ouverture (25) pratiquée dans la face avant de la partie de boîtier (10) ou soit disposée de manière à ce que le contact enfichable (7) puisse être mis en contact, à travers l'ouverture (25) pratiquée dans la première partie de boîtier (10), avec une contre-fiche,
et, lors d'une autre étape, la partie de boîtier (10) est reliée à une autre partie de boîtier (11) et est notamment refermée, dans lequel au moins une pointe de centrage (18, 19), réalisée de manière à se rétrécir vers une extrémité et reliée à l'autre partie de boîtier (11), s'engage à travers un orifice traversant (26, 27) de la carte de circuit imprimé (4, 5) jusqu'à ce que la pointe de centrage (18, 19) vienne buter par une section longitudinale par complémentarité de forme contre la carte de circuit imprimé dans la zone de l'orifice traversant (26, 27) de la carte de circuit imprimé et maintienne ainsi la carte de circuit imprimé dans le boîtier (10, 11) à une position prédéterminée.

10. Procédé selon la revendication 9,
dans lequel la carte de circuit imprimé (4, 5) est insérée par le haut dans la partie de boîtier (10) et est déplacée par coulissement horizontal (20) jusqu'à une position d'extrémité.

11. Procédé selon la revendication 10,
dans lequel la carte de circuit imprimé (4, 5) est déplacée (21) jusqu'à une position d'extrémité transversalement à son extension plane, après son déplacement le long de son extension plane.

12. Procédé selon l'une des revendications 9 à 11 précédentes,
**caractérisé en ce que** le boîtier (10, 11) est relié, en association avec la carte de circuit imprimé (4, 5), à une contre-fiche (35) reliée à un câble (41) et **en ce que** le boîtier (10, 11) forme un joint d'étanchéité dans la zone du contact enfichable (7) avec la contre-fiche (35).
